# EUROPEAN PATENT SPECIFICATION

(11) **EP 0 700 158 B1**
(45) Date of publication and mention of the grant of the patent: **29.04.1998**
(21) Application number: 94830414.2
(22) Date of filing: 31.08.1994
(51) Int. Cl.: H03K 17/082

(54) **Protection circuit against current overloads for electronic power devices**
Schutzschaltung gegen Überströme für elektronische Leistungsvorrichtungen
Circuit de protection contre les surintensités de courant pour dispositifs électroniques de puissance

(43) Date of publication of application: 06.03.1996
(73) Proprietor: SGS-THOMSON MICROELECTRONICS s.r.l., 20041 Agrate Brianza (Milano) (IT)
(72) Inventor: Botti, Edoardo, I-27029 Vigevano (Pavia) (IT); Chiozzi, Giorgio, I-20092 Cinisello Balsamo (MI) (IT)
(74) Representative: Botti, Mario

(56) References cited:
- DE-A- 4 005 813
- GB-A- 2 138 644
- US-A- 4 961 006

## Description

The present invention relates to a protection circuit against current overloads which can occur in electronic power devices.

Specifically the circuit to which the present invention relates finds application in the protection of electronic power devices comprising at output at least one bipolar or MOS power transistor.

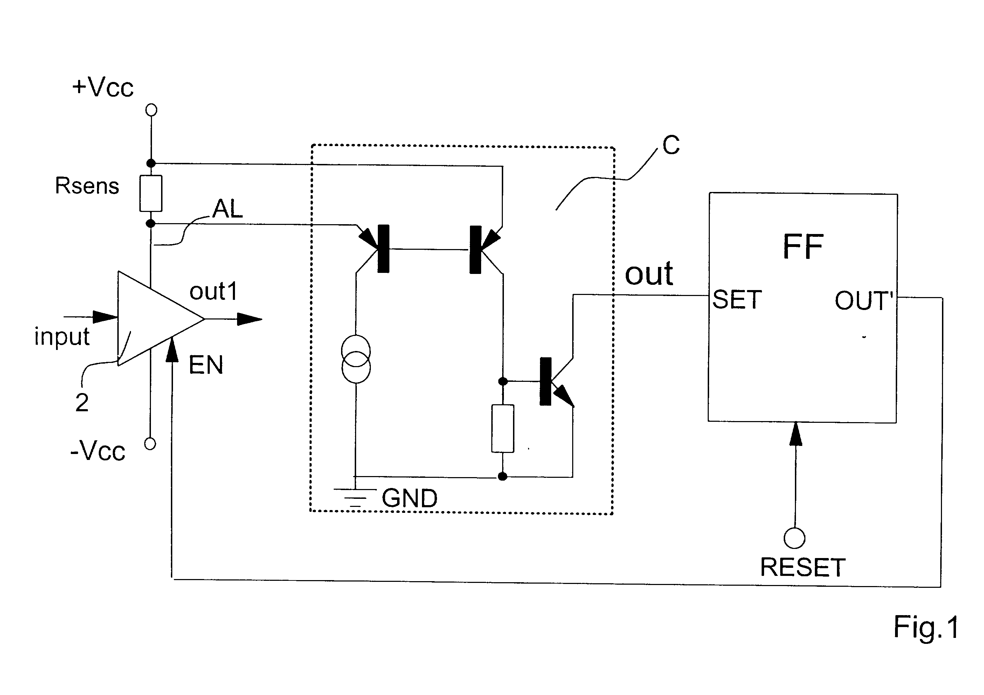

These devices must also have a driving terminal capable of turning them on or off. As known, to protect devices of the above mentioned type, circuits are used, e.g. like those shown in FIG. 1, comprising a threshold comparator C and a bistable or flip-flop circuit FF of the set/reset type connected together.

DE-A-40 05 813 discloses a protection circuit for an electronic power device with a sensing resistor and a current mirror. An excessive current unbalances the current mirror, thereby causing a detection signal to be generated. No latch mechanism is foreseen in the protection circuit. GB-A-2 138 644 discloses a protection circuit in which overload is detected in a comparator. A positive feedback is implemented for latching the overload state.

With reference to FIG. 1 the threshold comparator C has a first and a second input terminal connected to a first and a second terminal of a resistive sensor element Rsens inserted in a power line AL of the electronic power device 2.

The threshold comparator C also has an output terminal OUT connected to an input terminal SET of the flip-flop FF.

The flip-flop FF comprises in turn an output terminal OUT' connected to the driving terminal EN of the electronic power device 2 as well as a control terminal RESET driven by circuit means (not shown in FIG. 1 because conventional) coupled to the output of said device.

These circuit means are designed to determine that there are no irregularities due to current overloads in the operation of the electronic power device 2 and, if there are no irregularities, generate a reset signal of the flip-flop FF.

Operation of the protection circuit is as follows.

The threshold of the comparator C is adjusted so that it generates at output an activation signal for the flip-flop FF when the voltage on the resistive sensor Rsens exceeds a predetermined value as takes place e.g. in case of current overload on the power line AL of the electronic power device 2.

Once activated, the flip-flop FF modifies its state and generates an output signal which, through the driving terminal EN of the electronic power device 2, turns the latter off.

The electronic power device 2 remains off until the flip-flop FF modifies its state, i.e. until the reset signal generated by the above mentioned circuit means is applied at its control terminal.

Although advantageous in some ways, these circuits are quite complex.

Their complexity lies principally in the circuit diagram of the flip-flop FF.

The technical problem underlying the present invention is to conceive a protection circuit having structural and functional characteristics allowing simpler provision thereof.

Specifically the solution idea underlying the present invention is to replace the flip-flop FF with a feedback network of the threshold comparator C comprising a transistor appropriately connected so that the loop gain of the network would be greater than 1.

In this manner the protection circuit is a sort of regenerative circuit even without the flip-flop FF.

The protection circuit in accordance with the present invention is considerably simplified and consequently easier to manufacture.

The lesser complexity of the circuit also involves a decrease in production costs thereof.

The technical problem is solved by a protection circuit of the type indicated above and defined in the characterising part of the annexed claims.

The characteristics and advantages of the protection circuit in accordance with the present invention are set forth in the description of an embodiment thereof given below by way of non-limiting example with reference to the annexed drawings.

In the drawings:
FIG. 1 shows a diagram of a protection circuit in accordance with the known art,
FIG. 2 shows a diagram of a protection circuit in accordance with the present invention, and
FIG. 3 shows a possible embodiment of a switch shown in FIG. 2.

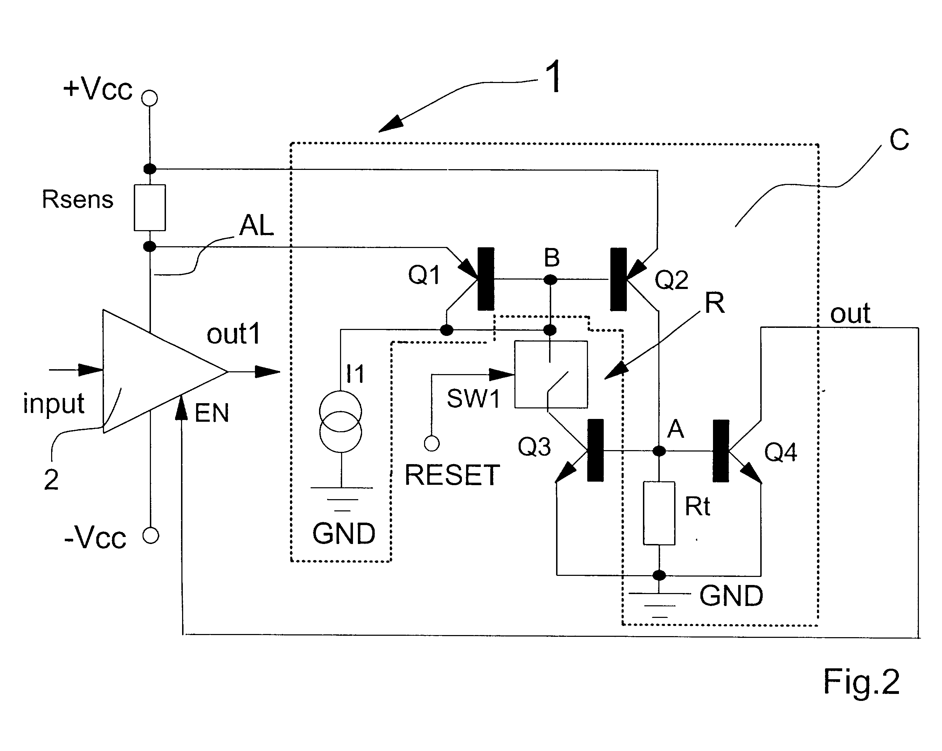

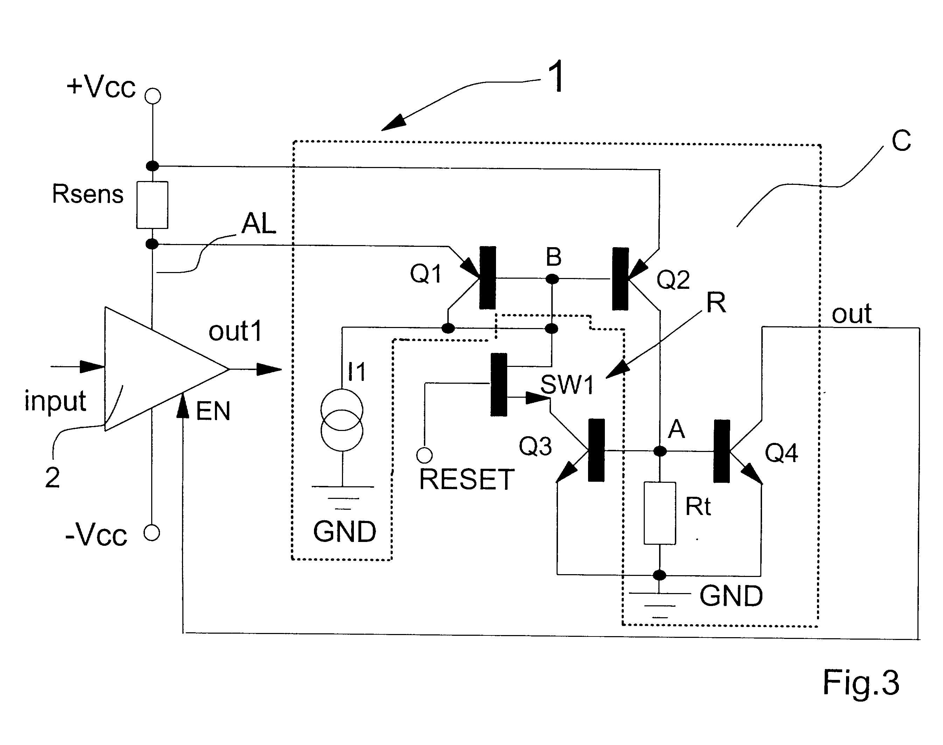

With reference to the figures 2 and 3 reference number 1 indicates as a whole and schematically a protection circuit provided in accordance with the present invention.

The protection circuit 1 comprises a threshold comparator C including a pair of bipolar input transistors Q1 and Q2 which form a current mirror and in the figure illustrated are the pnp type.

The input transistors Q1 and Q2 have emitter terminals which operate as inputs of the threshold comparator C and are connected to a power line AL of an electronic power device 2 and base terminals connected together in a first node B.

Furthermore the first input transistor Q1 has its base terminal and collector terminal connected together in such a manner as to suit them for operation virtually as a diode.

In FIG. 2 it is seen also that the power line AL of the electronic power device 2 is connected to a positive pole +Vcc of a power voltage generator by means of a first element Rsens, e.g. a resistive sensor.

This resistive sensor has opposing ends connected to the emitter terminals of the pair of input transistors Q1 and Q2.

It is noted that in FIG. 2 the electronic power device 2 is provided by a power amplifier but the protection circuit 1 can be applied to any device comprising at output at least one bipolar or MOS power transistor.

Again in FIG. 2 it is seen that the collector terminal of the first input transistor Q1 is connected to a terminal of a constant current generator I1 while the second input transistor Q2 has its collector terminal connected to a second circuitry node A of the threshold comparator C.

The second circuitry node A is in turn coupled with an output terminal OUT of the threshold comparator C by means of a fourth transistor Q4 which in the figure illustrated is the npn type.

Specifically the fourth transistor Q4 has its base terminal connected to the second circuitry node A, its emitter terminals connected to a potential reference, e.g. a signal ground GND, and its collector terminal connected to a driving terminal EN of the electronic power device 2. The threshold comparator C comprises also a second resistive element Rt inserted between the second circuitry node A and the potential reference GND. In the protection circuit 1 is also included a feedback network R for the threshold comparator C.

This feedback network R comprises at least one third transistor Q3, which in the figure illustrated is the npn type, appropriately connected so that the aforesaid network has loop gain greater than 1.

Specifically the third transistor Q3 has its base terminal connected to the second circuitry node A, its emitter terminal connected to the potential reference GND and its collector terminal coupled with the first node B.

The feedback network R comprises furthermore a switch SW1 connecting the collector terminal of the third transistor Q3 and the first node B.

This switch has a control terminal connected to driving circuit means not shown in FIG. 2 because conventional and coupled with an output terminal OUT1 of the electronic power device 2.

FIG. 3 shows a possible embodiment of the switch SW1 providing employment of an n-channel MOS transistor.

Specifically this transistor has its drain terminal connected to the first node B, its source terminal connected to the third transistor Q3 and its gate terminal connected to the driving circuit means.

There is now described the operation of the protection circuit 1 in accordance with the present invention with particular reference to an initial state in which the third and fourth transistors Q3 and Q4 are interdicted and the switch SW1 is closed.

Under these conditions if on the power line AL of the electronic power device 2 there is a current overload the voltage at the ends of the resistive sensor Rsens increases.

The increase in this voltage causes an increase in the voltage between the base terminal and the emitter terminal of the second input transistor Q2.

The voltage on the first node B remains fixed.

The increase of the voltage between the base terminal and the emitter terminal of the second input transistor Q2 causes a consequent increase in its collector current. With the increase in this current the voltage between the terminals of the second resistive element Rt also increases.

Since this voltage is equal to the voltage between the base terminal and the emitter terminals of both the transistors Q3 and Q4 an increase thereof causes the latter to pass from an interdiction state to a conduction state.

Under these conditions the fourth transistor Q4 generates an output signal of the threshold comparator C which, acting on the driving terminal EN, extinguishes the electronic power device 2.

The third transistor Q3, having passed into conduction, activates the feedback network R of the threshold comparator C.

All this is due to the fact that the transistor Q3 is connected to the second input transistor Q2 defining with the switch SW1 a feedback network R with loop gain greater than 1. More specifically, the feedback network R forms with the second input transistor Q2 a latch, which is set in overload condition.

Consequently the presence of this network causes the protection circuit 1 to be a sort of regenerative circuit. Indeed, having loop gain greater than 1, the feedback network R is capable of remaining active, holding in conduction state the fourth transistor Q4 even when on the power line AL of the electronic power device 2 there is no longer a current overload.

In this manner the electronic power device 2 remains extinguished until on the control terminal of the switch SW1 there is applied an appropriate reset signal generated by the driving circuit means coupled with the output of the device itself.

These driving circuit means are designed to determine that there are no longer any irregularities due to current overloads in the operation of the electronic power device 2 and, if there are no irregularities, generate the reset signal which opens the switch SW1 and deactivates the feedback network R.

Of course modifications and variations can be made to the circuit described above by way of nonlimiting example all however falling within the protective scope of the following claims.

Indeed, the protection circuit described above is used also when the power line AL of the electronic power device 2 is coupled with a negative pole Vcc of a power voltage generator.

In this case the pnp transistors are replaced with npn transistors and vice versa.

## Claims

1. Protection circuit against current overloads for an electronic power device (2), the protection circuit comprising at least one threshold comparator (C) having at least one output terminal (OUT) coupled with at least one driving terminal (EN) of the device (2) to be protected and including at least one pair of input transistors (Q1) and (Q2) forming a current mirror, having control terminals connected together in a first node (B) and first terminals operating as inputs of the threshold comparator (C), the second input transistor (Q2) having the first terminal connected to a power voltage (V_{cc}) and the first input transistor (Q1) having the first terminal connected to a power line (AL) of the electronic power device (2), the power voltage (V_{cc}) and the power line (AL) being connected by means of a sensor, said threshold comparator (C) comprising at least one second circuitry node (A) connected to one second terminal of the second input transistor (Q2) and coupled both to the output terminal (OUT) of the threshold comparator (C) and to a potential reference (GND) and characterised in that it comprises one feedback network (R) for said threshold comparator (C) inserted between the second circuitry node (A) and the first node (B), said feedback network (R) forming together with the second input transistor (Q2) a latch having a loop gain greater than one, which is set in overload condition.

2. Protection circuit in accordance with claim 1 characterised in that the feedback network (R) comprises at least one third transistor (Q3).

3. Protection circuit in accordance with claim 2 characterised in that the third transistor (Q3) has first and second terminals and one control terminal, the first terminal coupled to the first node (B), the second terminal connected to a potential reference (GND) and the control terminal connected to the second circuitry node (A).

4. Protection circuit in accordance with claims 1, 2 and 3 and characterised in that the first terminal of the third transistor (Q3) and the first node (B) are coupled by means of a switch (SW1) coupled to a control signal generated at an output of the electronic power device (2).

5. Protection circuit in accordance with claim 4 characterised in that the switch (SW1) is a MOS transistor.

6. Protection circuit in accordance with claim 5 characterised in that said MOS transistor has at least one control terminal driven by the control signal generated at an output by the electronic power device (2).

7. Protection circuit in accordance with claims 2, 3 and 4 characterised in that the third transistor (Q3) is an npn bipolar transistor.

8. Protection circuit in accordance with claims 2, 3 and 4 characterised in that the third transistor (Q3) is a pnp bipolar transistor.

## Patentansprüche

1. Schutzschaltung gegen Stromüberlastungen für elektronische Leistungsbauelemente (2), umfassend mindestens einen Schwellenwertkomparator (C) mit mindestens einem Ausgangsanschluß (OUT), der an mindestens einen Treiberanschluß (EN) des zu schützenden Bauelements (2) gekoppelt ist, und mindestens einem Paar, einen Stromspiegel bildenden Eingangstransistoren (Q1, Q2), deren Steueranschlüsse in einem ersten Knoten (B) zusammengeschaltet sind, und von denen erste Anschlüsse als Eingänge für den Schwellenwertkomparator (C) fungieren, wobei der zweite Eingangstransistor (Q2) mit dem ersten Anschluß an eine Spannungsquelle (Vcc) angeschlossen ist und der erste Eingangstransistor (Q1) mit dem ersten Anschluß an eine Versorgungsleitung (AL) des elektronischen Leistungsbauelements (2) angeschlossen ist, wobei die Versorgungsspannung (Vcc) und die Versorgungsleitung (AL) mittels eines Sensors verbunden sind, der Schwellenwertkomparator (C) mindestens einen zweiten Schaltungsknoten (A) aufweist, der an einen zweiten Anschluß des zweiten Eingangstransistors (Q2) und sowohl an den Ausgangsanschluß (OUT) des Schwellenwertkomparators (C) und an ein Referenzpotential (GND) angeschlossen ist, dadurch gekennzeichnet, daß sie ein Rückkopplungsnetzwerk (R) für den Schwellenwertkomparator (C) enthält, das zwischen den zweiten Schaltungsknoten (A) und den ersten Knoten (B) eingefügt ist, wobei das Rückkopplungsnetzwerk (R) zusammen mit dem zweiten Eingangstransistor (Q2) einen Zwischenspeicher mit einer Schleifenverstärkung von größer als Eins bildet, der im Überlastungszustand gesetzt wird.

2. Schutzschaltung nach Anspruch 1, dadurch gekennzeichnet, daß das Rückkopplungsnetzwerk (R) mindestens einen dritten Transistor (Q3) enthält.

3. Schutzschaltung nach Anspruch 2, dadurch gekennzeichnet, daß der dritte Transistor (Q3) einen ersten und einen zweiten Anschluß und einen Steueranschluß enthält, daß der erste Anschluß an den ersten Knoten (B) gekoppelt ist, der zweite Knoten an ein Referenzpotential (GND) gekoppelt ist, und der Steueranschluß an den zweiten Schaltungsknoten (A) angeschlossen ist.

4. Schutzschaltung nach Anspruch 1, 2 und 3, dadurch gekennzeichnet, daß der erste Anschluß des dritten Transistors (Q3) und der erste Knoten (B) über einen Schalter (SW1) gekoppelt sind, welcher ein Steuersignal erhält, welches an einem Ausgang des elektronischen Leistungsbauelements (2) gebildet wird.

5. Schutzschaltung nach Anspruch 4, dadurch gekennzeichnet, daß der Schalter (SW1) ein MOS-Transistor ist.

6. Schutzschaltung nach Anspruch 5, dadurch gekennzeichnet, daß der MOS-Transistor mindestens einen Steueranschluß aufweist, der von dem Steuersignal angesteuert wird, welches an einem Ausgang des elektronischen Leistungsbauelements (2) gebildet wird.

7. Schutzschaltung nach Anspruch 2, 3 und 4, dadurch gekennzeichnet, daß der dritte Transistor (Q3) ein NPN-Bipolartransistor ist.

8. Schutzschaltung nach Anspruch 2, 3 und 4, dadurch gekennzeichnet, daß der dritte Transistor (Q3) ein PNP-Bipolartransistor ist.

## Revendications

1. Circuit de protection contre les surintensités de courant pour un dispositif électronique de puissance (2), le circuit de protection comprenant au moins un comparateur de seuil (C) ayant au moins une borne de sortie (OUT) couplée avec au moins une borne de pilotage (EN) du dispositif (2) à protéger et comprenant au moins une paire de transistors d'entrée (Q1) et (Q2) formant un miroir de courant, ayant des bornes de commande connectées ensemble en un premier noeud (B) et des premières bornes fonctionnant en tant qu'entrées du comparateur de seuil (C), le second transistor d'entrée (Q2) ayant la première borne connectée à une tension d'alimentation (Vcc) et le premier transistor d'entrée (Q1) ayant la première borne connectée à une ligne d'alimentation (AL) du dispositif électronique de puissance (2), la tension d'alimentation (Vcc) et la ligne de puissance (AL) étant connectées par l'intermédiaire d'un détecteur, ledit comparateur de seuil (C) comprenant au moins un second noeud de circuit (A) connecté à une seconde borne du second transistor d'entrée (Q2) et couplé à la borne de sortie (OUT) du comparateur de seuil (C) ainsi qu'à un potentiel de référence (GND), et étant caractérisé en ce qu'il comprend un réseau de rétroaction (R) pour ledit comparateur de seuil (C) inséré entre le second noeud de circuit (A) et le premier noeud (B), ledit réseau de rétroaction (R) formant avec le second transistor d'entrée (Q2) un circuit de verrouillage ayant un gain de boucle supérieur à 1, qui est réglé dans des conditions de surintensité.

2. Circuit de protection selon la revendication 1, caractérisé en ce que le réseau de rétroaction (R) comprend au moins un troisième transistor (Q3).

3. Circuit de protection selon la revendication 2, caractérisé en ce que ledit troisième transistor (Q3) a des première et seconde bornes et une borne de commande, la première borne étant couplée au premier noeud (B), la seconde borne étant connectée à un potentiel de référence (GND), et la borne de commande étant connectée au second noeud de circuit (A).

4. Circuit de protection selon les revendications 1, 2 et 3, et caractérisé en ce que la première borne du troisième transistor (Q3) et le premier noeud (B) sont couplés par l'intermédiaire d'un commutateur (SW1) couplé à un signal de commande produit en une sortie du dispositif électronique de puissance (2).

5. Circuit de protection selon la revendication 4, caractérisé en ce que le commutateur (SW1) est un transistor MOS.

6. Circuit de protection selon la revendication 5, caractérisé en ce que ledit transistor MOS a au moins une borne de commande pilotée par le signal de commande produit en une sortie par le dispositif électronique de puissance (2).

7. Circuit de protection selon les revendications 2, 3 et 4, caractérisé en ce que le troisième transistor (Q3) est un transistor bipolaire npn.

8. Circuit de protection selon les revendications 2, 3 et 4, caractérisé en ce que le troisième transistor (Q3) est un transistor bipolaire pnp.
